# FASCICULE DE BREVET EUROPEEN

(11) **EP 3 648 346 B1**
(45) Date de publication et mention de la délivrance du brevet: **19.07.2023**
(21) Numéro de dépôt: 19205742.0
(22) Date de dépôt: 28.10.2019
(51) Int. Cl.: H01L 27/06, H03F 3/50, H03F 1/52, H01L 27/01, H01L 29/20, H01L 29/40, H01L 29/417, H01L 29/872

(54) **CIRCUIT DE POLARISATION D'UN COMPOSANT DE PUISSANCE**
VORSPANNUNGSSCHALTUNG EINES LEISTUNGSBAUELEMENTS
BIASING CIRCUIT OF A POWER COMPONANT

(30) Priorité: 31.10.2018 FR 1860122
(43) Date de publication de la demande: 06.05.2020
(73) Titulaire: Commissariat à l'Energie Atomique et aux Energies Alternatives, 75015 Paris (FR)
(72) Inventeur: BUCKLEY, Julien, 38054 GRENOBLE Cedex 9 (FR); MORVAN, Erwan, 38054 GRENOBLE Cedex 9 (FR)
(74) Mandataire: Hautier IP

(56) Documents cités:
- EP-A1- 2 811 520
- US-A1- 2012 217 542

## Description

### DOMAINE TECHNIQUE DE L'INVENTION

L'invention concerne les circuits de polarisation pour les composants de puissance. Elle trouve au moins une application particulièrement avantageuse dans le domaine des diodes Schottky à base de GaN et des transistors de type HEMT (acronyme anglais de « High Electron Mobility Transistor ») à base de GaN.

### ÉTAT DE LA TECHNIQUE

Les diodes et les transistors sont généralement conçus pour fonctionner de façon alternative entre un état passant et un état bloqué.

L'état passant permet au courant électrique de circuler entre une première et une deuxième électrode de ces composants, tandis que l'état bloqué stoppe la circulation de ce courant.

Ces composants peuvent être configurés pour fonctionner avec des courants d'intensité élevée et/ou des tensions de polarisation élevées.

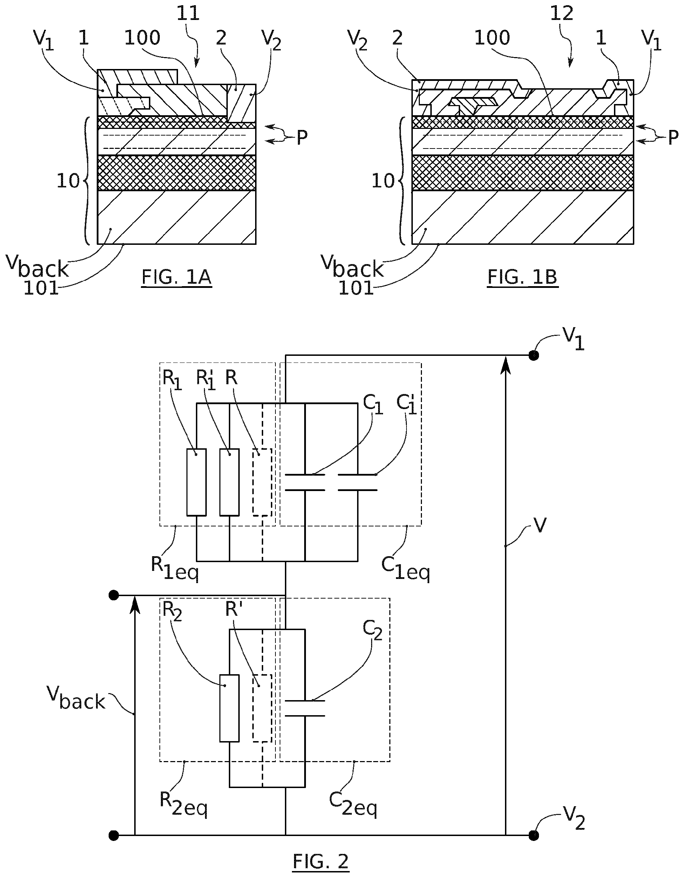

De tels composants de puissance sont généralement à base de GaN. Pour de tels composants de puissance à base de GaN, la polarisation à l'état bloqué peut induire un piégeage P de charges négatives dans des couches d'AlGaN et de GaN, tel qu'illustré aux figures 1A et 1B. Ce piégeage P limite alors le courant à l'état passant et dégrade les caractéristiques et les performances de ces composants à l'état passant.

Pour une diode Schottky 11, tel que celle illustré en figure 1A, cela se traduit notamment par une augmentation de la tension de polarisation à l'état passant.

Pour un transistor HEMT 12, tel que celui illustré en figure 1B, cela se traduit notamment par une augmentation de la résistance à l'état passant.

Pour ces composants, il est alors nécessaire de limiter la différence de potentiel entre la première électrode et/ou la deuxième électrode et une partie sous-jacente du substrat, du côté de la face arrière de ce substrat.

Un circuit de polarisation externe peut permettre de limiter cette différence de potentiel, et de réduire ainsi le piégeage.

Un inconvénient de cette solution est qu'un tel circuit de polarisation externe induit un encombrement supplémentaire pour le composant final.

Les documents EP 2811520 A1 et US 2012/217542 divulguent d'autres solutions particulières visant à limiter cette différence de potentiel.

Un objet de la présente invention est de pallier au moins en partie certains des inconvénients mentionnés ci-dessus.

Selon un aspect particulier, un objet de la présente invention est de proposer un système comprenant un composant de puissance et un circuit de polarisation du composant de puissance présentant un faible encombrement.

Un autre objet de la présente invention est de proposer un système comprenant un composant de puissance et un circuit de polarisation permettant d'obtenir un rapport sensiblement constant entre la différence de potentiels entre les première et deuxième électrodes et la différence de potentiels entre la première électrode et la face arrière du substrat du composant de puissance.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Pour atteindre cet objectif, un premier aspect de l'invention concerne un système comprenant un composant de puissance à base de GaN et un circuit de polarisation dudit composant de puissance. puissance conformément à la revendication indépendante 1 annexée.

Le composant de puissance est formé en face avant d'un substrat semiconducteur présentant une face avant et une face arrière.

Le composant de puissance présente un état passant et un état bloqué.

Le composant de puissance comprend une première électrode présentant à l'état passant un potentiel électrique V1 et une deuxième électrode présentant à l'état passant un potentiel électrique V2.

Avantageusement, selon l'invention le circuit de polarisation comprend un pont diviseur capacitif et un pont diviseur résistif formés au moins en partie sur le substrat semiconducteur et configurés pour maintenir en face arrière du substrat semiconducteur un potentiel électrique Vback tel que Vback soit sensiblement égal à k.V avec k un facteur de proportionnalité strictement compris entre 0 et 1, et V étant une tension de fonctionnement à l'état passant du composant telle que V = V1 - V2.

Le circuit de polarisation est configuré pour limiter une dégradation du fonctionnement à l'état passant du composant de puissance. En particulier, cette dégradation du fonctionnement est limitée lorsque le piégeage de charges est réduit.

Selon l'invention et de façon particulièrement avantageuse, l'utilisation d'un pont diviseur capacitif permet de maintenir le potentiel électrique Vback sensiblement constant lors d'un blocage dynamique du composant.

Le piégeage de charges en situation de blocage dynamique du composant est dès lors réduit.

L'utilisation d'un pont diviseur résistif permet de maintenir le potentiel électrique Vback sensiblement constant lors d'un blocage statique du composant.

Le piégeage de charges en situation de blocage statique du composant est dès lors réduit.

La formation de ces ponts diviseurs directement sur le substrat semiconducteur permet en outre de réduire l'encombrement d'un tel circuit de polarisation.

La première électrode de surface S1 forme avec la face arrière du substrat un premier condensateur de capacité C1 et de résistance de fuite R1.

La deuxième électrode de surface S2 forme avec la face arrière du substrat un deuxième condensateur de capacité C2 et de résistance de fuite R2.

Avantageusement, le circuit de polarisation selon la présente invention exploite ces premier et deuxième condensateurs pour former au moins en partie le pont diviseur capacitif et le pont diviseur résistif.

Selon l'invention, la formation d'une électrode additionnelle en face avant du substrat permet d'obtenir un condensateur plan additionnel. Cette électrode additionnelle est connectée à la première électrode et est polarisée au potentiel V1. Le condensateur additionnel présente ainsi une capacité C1' et une résistance de fuite R1'.

Le condensateur équivalent au premier condensateur et au condensateur additionnel présente ainsi une capacité C1eq = C1 + C1' et une résistance de fuite R1eq = R1.R1'/(R1+R1').

Le pont diviseur capacitif formé par les capacités C1eq et C2 permet ainsi de contrôler le potentiel Vback, comme illustré à la figure 2.

Pour obtenir Vback = k.(V1 - V2), le pont diviseur capacitif est configuré de sorte que C1eq = C2.k/(1 - k). Une possibilité avantageuse pour une telle configuration consiste à dimensionner l'électrode additionnelle de façon à ce qu'elle présente une surface S1' telle que S1' = S2.k/(1 - k) - S1.

Le circuit de polarisation selon la présente invention exploite les premier et deuxième condensateurs, et le condensateur additionnel pour former au moins en partie le pont diviseur résistif.

En particulier, le pont diviseur résistif formé par les résistances de fuite R1eq et R2 peut permettre de contrôler le potentiel Vback, comme illustré à la figure 2.

Pour optimiser R1eq, une possibilité consiste à diminuer R1' en effectuant une gravure de la face avant du substrat semiconducteur préalablement à la formation de l'électrode additionnelle. L'épaisseur de substrat entre ladite électrode additionnelle et la face arrière du substrat est alors diminuée, ce qui diminue R1'.

Selon une possibilité préférée mais optionnelle, le pont diviseur résistif comprend des résisteurs complémentaires formés en face avant du substrat à base de GaN. Ces résisteurs complémentaires comprennent chacun avantageusement une série d'éléments résistifs alternés, ces éléments résistifs étant formés par un élément métallique et une zone isolante adjacente. Il est ainsi possible de calibrer précisément et facilement la valeur des résistances de ces résisteurs complémentaires, en multipliant le nombre d'éléments résistifs en série.

En particulier, un tel résisteur complémentaire en face avant d'un substrat à base de GaN peut comprendre une série d'éléments résistifs alternés, chacun de ces éléments résistifs comprenant un élément métallique en face avant du substrat bordé par une zone isolante dans le GaN.

Un procédé de formation d'un tel résisteur peut comprendre une étape de formation d'une pluralité d'éléments métalliques en face avant du substrat, et une étape de formation d'une pluralité de zones isolantes dans le GaN, chacune des zones isolantes de ladite pluralité de zones isolantes bordant chacun des éléments métalliques de ladite pluralité d'éléments métalliques.

Selon une possibilité préférée, la pluralité de zones isolantes est formée par une implantation d'hélium dans le GaN suivie d'un recuit.

### BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
- La FIGURE 1A montre un schéma en coupe d'une diode Schottky à base de GaN selon l'art antérieur ;
- La FIGURE 1B montre un schéma en coupe d'un transistor HEMT à base de GaN selon l'art antérieur ;
- La FIGURE 2 montre un circuit de polarisation selon un mode de réalisation de la présente invention ;
- La FIGURE 3A montre une vue de dessus d'une diode Schottky à base de GaN équipée d'un circuit de polarisation selon un premier mode de réalisation de la présente invention ;
- La FIGURE 3B montre des tensions V et Vback d'après des résultats de simulation en situation de blocage statique pour une diode Schottky à base de GaN équipée d'un circuit de polarisation selon le premier mode de réalisation illustré en FIGURE 3A ;
- La FIGURE 3C montre des tensions V et Vback d'après des résultats de simulation en situation de blocage dynamique pour une diode Schottky à base de GaN équipée d'un circuit de polarisation selon le premier mode de réalisation illustré en FIGURE 3A ;
- La FIGURE 4 montre une vue de dessus d'une diode Schottky à base de GaN équipée d'un circuit de polarisation selon un deuxième mode de réalisation de la présente invention ;
- La FIGURE 5 montre une vue de dessus d'une diode Schottky à base de GaN équipée d'un circuit de polarisation selon un troisième mode de réalisation de la présente invention ;
- La FIGURE 6A montre une vue de dessus d'une diode Schottky à base de GaN équipée d'un circuit de polarisation selon un quatrième mode de réalisation de la présente invention ;
- La FIGURE 6B montre des tensions V et Vback d'après des résultats de simulation en situation de blocage statique pour une diode Schottky à base de GaN équipée d'un circuit de polarisation selon le quatrième mode de réalisation illustré en FIGURE 6A ;
- La FIGURE 6C montre des tensions V et Vback d'après des résultats de simulation en situation de blocage dynamique pour une diode Schottky à base de GaN équipée d'un circuit de polarisation selon le quatrième mode de réalisation illustré en FIGURE 6A ;
- La FIGURE 7 illustre en vue de dessus une résistance additionnelle selon un mode de réalisation de la présente invention ;
- La FIGURE 8 une vue de dessus d'un transistor HEMT à base de GaN équipé d'un circuit de polarisation selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.

En particulier, les épaisseurs et dimensions des différentes couches et portions des dispositifs illustrés ne sont pas représentatives de la réalité.

### DESCRIPTION DÉTAILLÉE DE L'INVENTION

Avant d'entamer une revue détaillée de modes de réalisation de l'invention, il est rappelé que l'invention comprend notamment les caractéristiques optionnelles ou non-optionnelles i-après pouvant être utilisées en association ou alternativement :
- Selon l'invention, le pont diviseur capacitif comprend un premier condensateur équivalent présentant une première capacité équivalente C1eq et un deuxième condensateur équivalent présentant une deuxième capacité équivalente C2eq telles que 0,9.C2eq.k/(1 - k) ≤ C1eq ≤ 1,1.C2eq.k/(1 - k).
   Cela permet de maintenir une tension de polarisation Vback en blocage dynamique telle que : 0,9.k.V ≤ Vback ≤ 1,1.k.V
- Selon l'invention, le pont diviseur résistif comprend un premier résisteur équivalent présentant une première résistance équivalente R1eq et un deuxième résisteur équivalent présentant une deuxième résistance équivalente R2eq telles que 0,9.R2eq.(1 - k)/k ≤ R1eq ≤ 1,1.R2eq.(1 - k)/k.
   Cela permet de maintenir une tension de polarisation Vback en blocage statique telle que : 0,9.k.V ≤ Vback ≤ 1,1.k.V
- Selon l'invention, le premier condensateur équivalent comprend un premier condensateur et un condensateur additionnel, le premier condensateur étant formé par le substrat et la première électrode en face avant du substrat, et présentant une première capacité C1 entre la face arrière du substrat et la première électrode, telle que C1 = E S1/e avec S1 une surface de la première électrode, e une épaisseur nominale du substrat, et E une permittivité du substrat, et le condensateur additionnel étant formé par le substrat et une électrode additionnelle en face avant du substrat connectée électriquement à la première électrode, et présentant une capacité additionnelle C1' entre la face arrière du substrat et l'électrode additionnelle, telle que C1' = E S1'/e avec S1' une surface de l'électrode additionnelle, e l'épaisseur nominale du substrat, et E la permittivité du substrat, de sorte que la première capacité équivalente C1eq = C1 + C1'. La permittivité diélectrique E peut être une valeur moyenne entre une valeur de permittivité d'un substrat silicium (Si) comprenant des couches de nitrure (GaN/AlN/AlGaN) en surface et une valeur de permittivité d'un substrat Si sans lesdites couches. L'épaisseur nominale e peut être sensiblement égale à une épaisseur des couches de nitrure en surface d'un substrat Si et une épaisseur de silicium déplété dudit substrat Si, notamment au niveau d'un point de polarisation statique du substrat.
- Selon l'invention, le deuxième condensateur équivalent comprend un deuxième condensateur formé par le substrat et la deuxième électrode en face avant du substrat, et présentant une deuxième capacité C2 entre la face arrière du substrat et la deuxième électrode, telle que C2 = E S2/e avec S2 une surface de la deuxième électrode, e une épaisseur nominale du substrat, et E une permittivité du substrat, de sorte que la deuxième capacité équivalente C2eq = C2. Les deux modes de réalisation précédents permettent de former le pont diviseur capacitif directement au niveau du composant, en partie sur le même substrat que le composant. Cette solution est simple à mettre en oeuvre.
- Selon l'invention, le premier résisteur équivalent comprend un premier résisteur et un résisteur additionnel, le premier résisteur étant formé par le substrat et la première électrode en face avant du substrat, et présentant une première résistance de fuite R1 entre la face arrière du substrat et la première électrode, telle que R1 = e/s.S1 avec S1 une surface de la première électrode, e une épaisseur nominale du substrat, et s une conductivité du substrat, et le résisteur additionnel étant formé par le substrat et une électrode additionnelle en face avant du substrat connectée électriquement à la première électrode, et présentant une résistance de fuite additionnelle R1' entre la face arrière du substrat et l'électrode additionnelle, telle que R1' = e/s.S1' avec S1' une surface de l'électrode additionnelle, e l'épaisseur nominale du substrat, et s la conductivité du substrat, de sorte que la première résistance équivalente R1eq soit telle que 1/R1eq = 1/R1 + 1/R1'. La conductivité s du substrat peut notamment être prise au niveau d'un point de polarisation entre les première et deuxième résistances de fuite R1, R1'.
- Selon l'invention, le deuxième résisteur équivalent comprend un deuxième résisteur formé par le substrat et la deuxième électrode en face avant du substrat, et présentant une deuxième résistance de fuite R2 entre la face arrière du substrat et la deuxième électrode, telle que R2 = e/s.S2 avec S2 une surface de la deuxième électrode, e une épaisseur nominale du substrat, et s une conductivité du substrat, de sorte que la deuxième résistance équivalente R2eq = R2.
   Les deux modes de réalisation précédents permettent de former le pont diviseur résistif directement au niveau du composant, en partie sur le même substrat que le composant. Cette solution est simple à mettre en oeuvre.
- Selon un mode de réalisation, les première et deuxième électrodes présentent chacune des doigts et sont au moins partiellement interdigitées au niveau d'une zone d'interdigitation et l'électrode additionnelle est située en bordure de la zone d'interdigitation.
   Cela permet de concevoir une électrode additionnelle en fonction du besoin, pour une même conception de composant.
- Selon un mode de réalisation, le substrat situé entre l'électrode additionnelle en face avant et la face arrière présente une épaisseur e' strictement inférieure à l'épaisseur nominale e du substrat, de sorte que la résistance additionnelle de fuite R1' = e'/s.S1' soit diminuée.
   Cela permet d'optimiser la résistance additionnelle de fuite R1'. Cela permet par exemple d'obtenir un couple R1' et C1' optimisé, compatible avec respectivement un pont diviseur résistif et un pont diviseur capacitif présentant un même facteur de proportionnalité k.
- Selon un mode de réalisation, les première et deuxième électrodes présentent chacune des doigts et sont au moins partiellement interdigitées au niveau d'une zone d'interdigitation, et l'électrode additionnelle présente des doigts additionnels prolongeant les doigts de la première électrode selon une direction en largeur desdits doigts, de sorte à former des doigts élargis présentant une largeur strictement supérieure, de préférence au moins cinq fois supérieure, à une largeur des doigts de la deuxième électrode.
   Cela permet d'obtenir un circuit de polarisation compact, directement au sein du composant.
- Selon un mode de réalisation, le premier résisteur équivalent comprend un premier résisteur complémentaire formé en face avant du substrat et présentant respectivement une première résistance complémentaire R de sorte que la première résistance équivalente R1eq soit telle que 1/R1eq = 1/R1 + 1/R1' + 1/R.
- Selon un mode de réalisation, le deuxième résisteur équivalent comprend un deuxième résisteur complémentaire formé en face avant du substrat et présentant une deuxième résistance complémentaire R' de sorte que la deuxième résistance équivalente R2eq soit telle que 1/R2eq = 1/R2 + 1/R'.
   Les deux modes de réalisation précédents permettent de régler plus précisément les première et deuxième résistances équivalentes pour former un pont diviseur résistif présentant le facteur de proportionnalité k.
   Cela permet en outre d'optimiser l'intégration de ces premier et deuxième résisteurs complémentaires lors de la formation du composant. En particulier, certaines étapes de la formation du composant et de la formation des résisteurs complémentaires peuvent être communes, ce qui diminue *in fine* le nombre d'étapes nécessaires pour former le circuit de polarisation.
- Selon un mode de réalisation, les premier et deuxième résisteurs complémentaires comprennent chacun une série d'éléments résistifs, lesdits éléments résistifs étant formés par un élément métallique et une zone isolante alternées.
   Cela permet de former simplement les premier et deuxième résisteurs complémentaires, à partir d'étapes technologiques standard de la microélectronique. Cela permet également de régler précisément la valeur des résistances complémentaires R, R'.
- Selon un mode de réalisation, le substrat semiconducteur comprend du GaN en face avant et la zone isolante est formée par une implantation d'hélium dans le GaN suivie d'un recuit.
   Cela permet d'obtenir un comportement ohmique des résisteurs complémentaires.
- Selon un mode de réalisation, le facteur de proportionnalité est choisi tel que 0,7 < k < 0,9.
   Cela permet de limiter la dégradation du fonctionnement du composant à l'état passant. Cela permet par exemple de limiter la tension de polarisation d'une diode Schottky à l'état passant. Cela permet par exemple de limiter l'augmentation de la résistance dans un transistor HEMT à l'état passant.
- Selon un mode de réalisation, le composant de puissance est pris parmi une diode Schottky et un transistor HEMT.
- Selon l'invention, le composant de puissance est à base de nitrure de gallium GaN.

L'invention selon son aspect séparable comprend notamment les caractéristiques optionnelles ci-après pouvant être utilisées en association ou alternativement :
- Selon un mode de réalisation du procédé de formation du résisteur, l'implantation d'Hélium se fait à une dose d'environ 5×10¹⁴/cm².
- Selon un mode de réalisation du procédé de formation du résisteur, le recuit se fait à 800°C environ.

Dans la présente invention, on entend par « transistors de type HEMT » des transistors à effet de champ à haute mobilité d'électrons, parfois également désignés par le terme de transistor à effet de champ à hétérostructure. Un tel transistor inclut la superposition de deux couches semi-conductrices ayant des bandes interdites différentes qui forment un puit quantique à leur interface. Des électrons sont confinés dans ce puits quantique pour former un gaz bidimensionnel d'électrons. Pour des raisons de tenue en haute tension et en température, le matériau semi-conducteur de ces transistors est choisi de façon à présenter une large bande d'énergie interdite.

Parmi les transistors HEMT à large bande d'énergie interdite, les transistors à base de nitrure de gallium sont très prometteurs.

Il est précisé que, dans le cadre de la présente invention, le dépôt d'une première couche par exemple en AlGaN sur une deuxième couche par exemple en GaN, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément. Par exemple et de façon connue en soi dans le domaine des transistors de type HEMT à base de GaN, une fine couche en AIN peut être intercalée entre deux couches semi-conductrices en GaN et en AlGaN.

On entend par un substrat, un dispositif, une couche, « à base » d'un matériau A, un substrat, un dispositif, une couche comprenant ce matériau A uniquement ou ce matériau A et éventuellement d'autres matériaux, par exemple des éléments d'alliage, des impuretés ou des éléments dopants, le matériau A présentant des propriétés avantageuses pour le substrat, le dispositif, ou la couche. Ainsi, une diode ou un transistor à base de nitrure de gallium (GaN) comprend une partie active en GaN, avec éventuellement des portions dopées, ou en alliage AlGaN par exemple.

Dans la suite, le maintien d'une valeur nominale, par exemple une valeur de potentiel en face arrière proportionnelle à la tension de fonctionnement du composant, signifie que cette valeur ne présente pas de variations significatives dans le temps pendant lequel elle est maintenue. En particulier, ces variations sont inférieures à 10% de la valeur, de préférence à 5% de la valeur.

Dans la suite, les termes « sensiblement », « environ », « de l'ordre de » signifient « à 10% près ».

Il est précisé que dans le cadre de la présente invention, l'épaisseur d'une couche ou du substrat se mesure selon une direction perpendiculaire à la surface selon laquelle cette couche ou ce substrat présente son extension maximale. Sur les figures 1A et 1B, l'épaisseur est prise selon la verticale.

Dans la présente demande de brevet, un résisteur est un dipôle résistif présentant un comportement de conducteur ohmique essentiellement caractérisé par sa résistance électrique. Il est également couramment appelé « résistance ».

Un condensateur est un dipôle capacitif essentiellement caractérisé par sa capacité électrique. Dans la présente demande de brevet, il est également couramment appelé « capacité ».

Dans la suite, le terme « résistance » renvoie donc soit au composant « résisteur », soit à la propriété physique « résistance électrique ».

Dans la suite, le terme « capacité » renvoie donc soit au composant « condensateur », soit à la propriété physique « capacité électrique ».

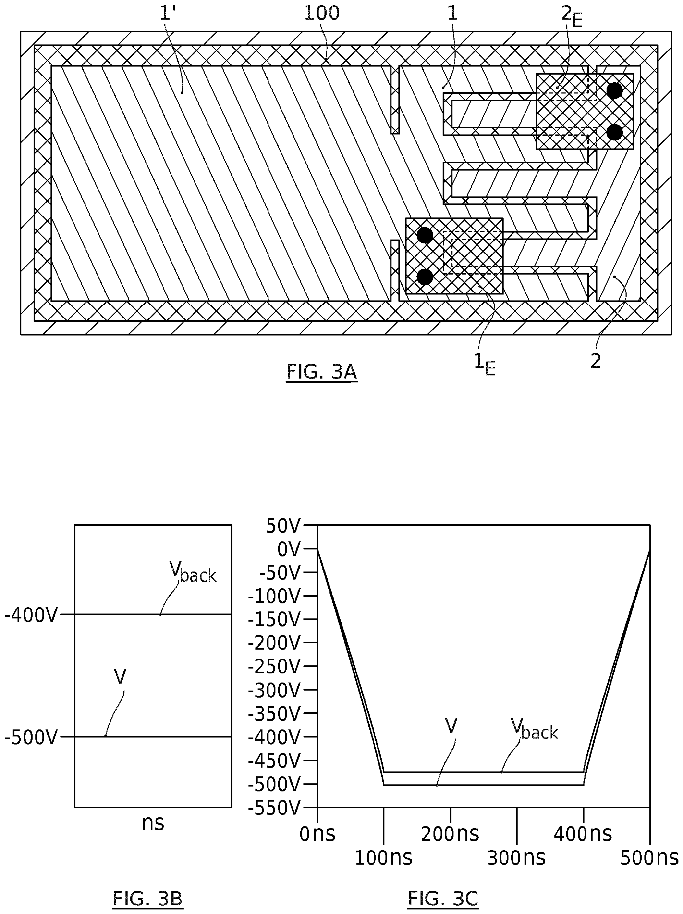

Selon l'invention, un premier mode de réalisation du circuit de polarisation va maintenant être décrit en référence à la figure 3A.

Dans la description qui va suivre, le composant de puissance intégrant ce circuit de polarisation est une diode Schottky à base de GaN sans que cela soit limitatif. En effet, la description qui suit s'applique également à d'autres composants de puissance, et en particulier aux transistors de type HEMT.

La diode Schottky peut comprendre un premier plot de connexion 1E connecté à une première électrode 1 métallique formant une première série de doigts, et comprenant un deuxième plot de connexion 2E connecté à une deuxième électrode 2 métallique formant une deuxième série de doigts.

Les première et deuxième électrodes 1, 2 sont formées en face avant 100 du substrat 10.

Les première et deuxième séries de doigts sont de préférence interdigitées.

Les première et deuxième séries de doigts comprennent de préférence sensiblement le même nombre de doigts, compris entre 15 et 50 par exemple.

Les première et deuxième séries de doigts peuvent comprendre par exemple 26 doigts.

Chacun de ces doigts peut présenter une longueur comprise entre 100 µm et 5mm, par exemple de l'ordre de 1mm, et une largeur comprise entre 3 µm et 50µm, par exemple de l'ordre de 15µm.

Les doigts de la première série peuvent présenter une longueur et/ou une largeur égale(s) respectivement à la longueur et/ou la largeur des doigts de la deuxième série.

Tel qu'illustré à la figure 2, le circuit de polarisation comprend un pont diviseur capacitif comprenant une première partie de capacité C1eq et une deuxième partie de capacité C2eq, de sorte que Vback = V. C1eq/(C1eq + C2eq).

Ce pont diviseur capacitif permet de maintenir le potentiel électrique Vback sensiblement constant lors d'un blocage dynamique du composant de puissance.

Dès lors, Vback = k.V avec k le facteur de proportionnalité de valeur k = C1eq/(C1eq + C2eq) en blocage dynamique.

La première partie du pont diviseur capacitif du circuit de polarisation est réalisée en connectant une électrode additionnelle 1' à la première électrode 1.

Cette électrode additionnelle 1' est formée en face avant 100 du substrat. Elle peut être formée avantageusement en même temps que la première électrode 1.

Elle est de préférence formée par des procédés standards de la microélectronique, par exemple par un procédé de « lift off », ou par un procédé de gravure sèche RIE (acronyme anglais de « Reactive Ion Etching »). Cela permet de minimiser les coûts de réalisation d'un tel circuit de polarisation.

Une telle électrode additionnelle 1' connectée à la première électrode 1 en face avant 100 du substrat forme avec la face arrière 101 du substrat un premier condensateur plan de capacité équivalente C1eq = C1 + C1' où C1 est la capacité formée entre la face arrière 101 du substrat et la première électrode 1, et C1' est la capacité formée entre la face arrière 101 et l'électrode additionnelle 1'.

Dans le cas du condensateur plan, C1 = E S1/e et C1' = E S1'/e avec S1 la surface de la première électrode, S1' la surface de l'électrode additionnelle 1', e l'épaisseur du substrat prise entre la face avant 100 et la face arrière 101, et E la permittivité du substrat. Les surfaces sont mesurées dans un plan parallèle au plan dans lequel s'étend principalement le substrat 10. Sur la figure 3A, ce plan correspond au plan de la feuille. L'épaisseur e du substrat 10 est mesurée perpendiculairement au plan de la feuille.

La deuxième partie du pont diviseur capacitif du circuit de polarisation est formée par la deuxième électrode 2.

Cette deuxième électrode 2 en face avant 100 du substrat 10 forme avec la face arrière 101 du substrat un deuxième condensateur plan de capacité équivalente C2eq = C2.

Dans le cas du condensateur plan, C2 = E S2/e avec S2 la surface de la deuxième électrode, e l'épaisseur du substrat 10 prise entre la face avant 100 et la face arrière 101, et E la permittivité du substrat 10.

Les surfaces S1, S2 des première et deuxième électrodes 1, 2 peuvent être sensiblement égales.

La surface S1' de l'électrode additionnelle 1' peut donc être avantageusement dimensionnée de manière à obtenir la capacité C1eq souhaitée.

En particulier, C1eq peut être choisie telle que k = 0,8. Cela permet d'améliorer la tenue en tension du composant de puissance en blocage dynamique.

Tel qu'illustré à la figure 2, le circuit de polarisation comprend un pont diviseur résistif comprenant une première partie de résistance R1eq et une deuxième partie de résistance R2eq, de sorte que Vback = V. R2eq/(R1eq + R2eq).

Ce pont diviseur résistif permet de maintenir le potentiel électrique Vback sensiblement constant lors d'un blocage statique du composant de puissance.

Dès lors, Vback = k.V avec k le facteur de proportionnalité de valeur k = R2eq/(R1eq + R2eq) en blocage statique.

La première partie du pont diviseur résistif du circuit de polarisation est formée à partir des fuites en courant du premier condensateur plan.

Ce premier condensateur plan présente en effet une première résistance équivalente R1eq telle que 1/R1eq = 1/R1 + 1/R1' où R1 est la première résistance de fuite entre la première électrode 1 en face avant 100 et la face arrière 101 du substrat, et R1' est la résistance de fuite additionnelle entre l'électrode additionnelle 1' en face avant 100 et la face arrière 101 du substrat 10.

Dans le cas du condensateur plan, R1 = e/s.S1 et R1' = e/s.S1' avec S1 la surface de la première électrode 1, S1' la surface de l'électrode additionnelle 1', e l'épaisseur du substrat 10 prise entre la face avant 100 et la face arrière 101, et s la conductivité du substrat 10.

La deuxième partie du pont diviseur résistif du circuit de polarisation est formée à partir des fuites en courant du deuxième condensateur plan.

Ce deuxième condensateur plan présente en effet une deuxième résistance équivalente R2eq = R2.

Dans le cas du condensateur plan, R2 = e/s.S2 avec S2 la surface de la deuxième électrode 2, e l'épaisseur du substrat 10 prise entre la face avant 100 et la face arrière 101, et s la conductivité du substrat 10.

Les surfaces S1, S2 des première et deuxième électrodes 1, 2 peuvent être sensiblement égales.

La surface S1' de l'électrode additionnelle 1' peut donc être avantageusement dimensionnée de manière à obtenir la résistance R1eq souhaitée.

En particulier, R1eq peut être choisie telle que k = 0,8. Cela permet d'améliorer la tenue en tension du composant de puissance en blocage statique.

Selon l'invention, l'ajout d'une seule électrode additionnelle 1' permet à la fois de former un pont diviseur capacitif et un pont diviseur résistif. La conception du circuit de polarisation est donc simplifiée. La réalisation du circuit de polarisation requiert en outre peu d'étapes technologiques. Le coût de cette réalisation est ainsi diminué.

Selon cet exemple, le dimensionnement de l'électrode additionnelle 1' privilégie la tenue en tension du composant de puissance en blocage statique. La surface S1' est alors de l'ordre de 3,8 mm².

Une simulation de la tension Vback obtenue en situation de blocage statique d'une part et en situation de blocage dynamique d'autre part est illustrée aux figures 3B et 3C.

La tension Vback ainsi obtenue en situation de blocage statique est de - 400V pour une tension V = -500V (figure 3B). Le facteur de proportionnalité k vaut 0,8 en blocage statique.

La tension Vback ainsi obtenue en situation de blocage dynamique est de -475V pour une tension V = -500V (figure 3C).

D'autres modes de réalisation du circuit de polarisation selon l'invention peuvent être envisagés. Seules les caractéristiques distinctes du premier mode de réalisation sont décrites ci-après, les autres caractéristiques non décrites étant réputées identiques à celles du premier mode de réalisation. De même, les avantages techniques mentionnés pour le mode de réalisation des figures 3A à 3C, sont, sauf indication contraire, applicables aux modes de réalisation qui suivent.

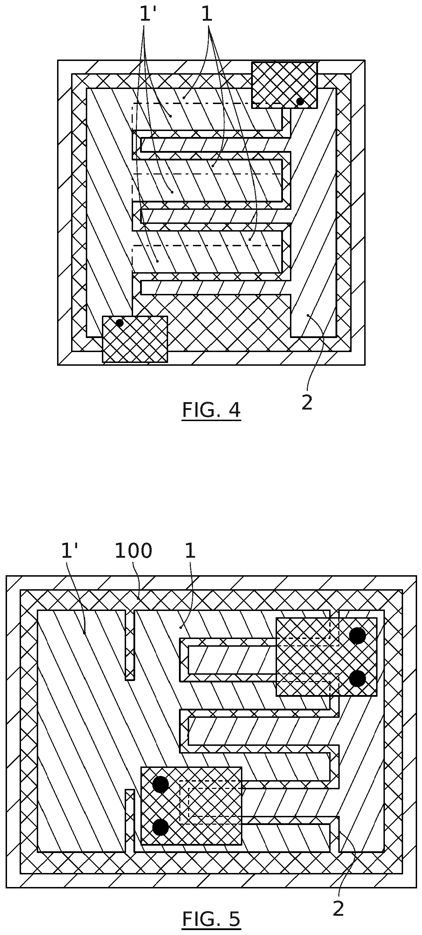

Selon un deuxième mode de réalisation illustré à la figure 4, la surface S1' de l'électrode additionnelle 1' peut être directement distribuée au niveau des doigts de la première série de doigts.

L'électrode additionnelle 1' se présente dès lors sous forme de doigts additionnels dans la continuité des doigts de la première série de doigts de la première électrode 1.

En particulier, chaque doigt de cette première série de doigts de la première électrode 1 peut être élargi de façon à ce que la surface initiale S1 de la première électrode 1 devienne la surface totale S1 + S1'.

L'électrode additionnelle 1' et la première électrode 1 peuvent donc former une seule et même électrode comprenant une seule série de doigts élargis, chacun de ces doigts élargis comprenant un doigt de la première électrode 1 et un doigt additionnel de l'électrode additionnelle 1'. Chaque doigt de la première électrode 1 est ainsi contigu à un doigt additionnel de l'électrode additionnelle 1'. De préférence, il n'y a pas de discontinuité de matière entre un doigt de la première électrode 1 et un doigt additionnel de l'électrode additionnelle 1'.

Par exemple, la largeur de chaque doigt élargi, formé par l'association de la première électrode 1 et de l'électrode additionnelle 1', est supérieure ou égale à 2, et de préférence à 5 fois, la largeur des doigts de la deuxième électrode 2.

La largeur des doigts est mesurée selon une direction contenue dans le plan du substrat et perpendiculaire à une direction selon laquelle les doigts s'étendent principalement.

Les ponts diviseurs capacitifs et résistifs peuvent être formés de la même façon que dans le premier mode de réalisation.

Par exemple, pour distribuer la surface S1' de l'ordre de 3,8 mm² sur l'ensemble des 26 doigts de la première série de doigts, les doigts présentant initialement une largeur de 15µm et une longueur de 1mm peuvent chacun être élargis de 146 µm environ. Leur largeur finale est alors d'environ 161µm.

Pour un autre dimensionnement de la surface S1' de l'ordre de 1 mm², les doigts présentant initialement une largeur de 15µm et une longueur de 1mm peuvent chacun être élargis de 35 µm environ. Leur largeur finale est alors d'environ 50µm.

Ce deuxième mode de réalisation permet d'intégrer directement le circuit de polarisation au sein du composant de puissance. Cela permet d'implanter plus facilement ce composant et/ou d'augmenter la compacité de ce composant.

Selon un troisième mode de réalisation illustré à la figure 5, le substrat peut être gravé préalablement à la formation de l'électrode additionnelle 1', de façon à diminuer l'épaisseur e' du substrat sous l'électrode additionnelle 1', entre la face avant 100 et la face arrière 101.

La gravure est de préférence une gravure des couches à base de GaN en face avant 100 du substrat.

La résistance additionnelle R1' = e'/s.S1' peut ainsi être avantageusement diminuée.

Un tel mode de réalisation permet de limiter voire éliminer la disparité entre la tension Vback en situation de blocage statique et la tension Vback en situation de blocage dynamique.

La profondeur de gravure est de préférence choisie afin d'ajuster la résistance R1' en fonction de la surface S1' de l'électrode additionnelle 1', de façon à optimiser à la fois le pont diviseur résistif et le pont diviseur capacitif.

Une méthode semi-empirique permettant de dimensionner la profondeur de gravure nécessaire en fonction de la surface S1' de l'électrode additionnelle 1' comprend de préférence les étapes suivantes :
- Déterminer la tension Vback souhaitée à partir de la meilleure caractéristique du composant en mode passant suite au blocage dudit composant, pour différentes tensions Vback. La valeur de tension Vback souhaitée correspond à celle qui dégrade le moins la caractéristique du composant en mode passant.
- Calculer les valeurs de capacité C1' et de résistance R1' souhaitées permettant d'atteindre la tension Vback souhaitée pour optimiser la différence de tension V - Vback entre les première et deuxième électrodes 1, 2 en face avant 100 et la face arrière 101,
- Réaliser différentes électrodes additionnelles pour S1' donnée et pour différentes profondeurs de gravure du GaN,
- Mesurer les différentes valeurs des capacités C1' et des résistances R1' pour chacune des différentes électrodes additionnelles en fonction de la profondeur de gravure,
- Déterminer la profondeur de gravure pour laquelle les couples capacité/résistance correspondent sensiblement aux valeurs calculées.

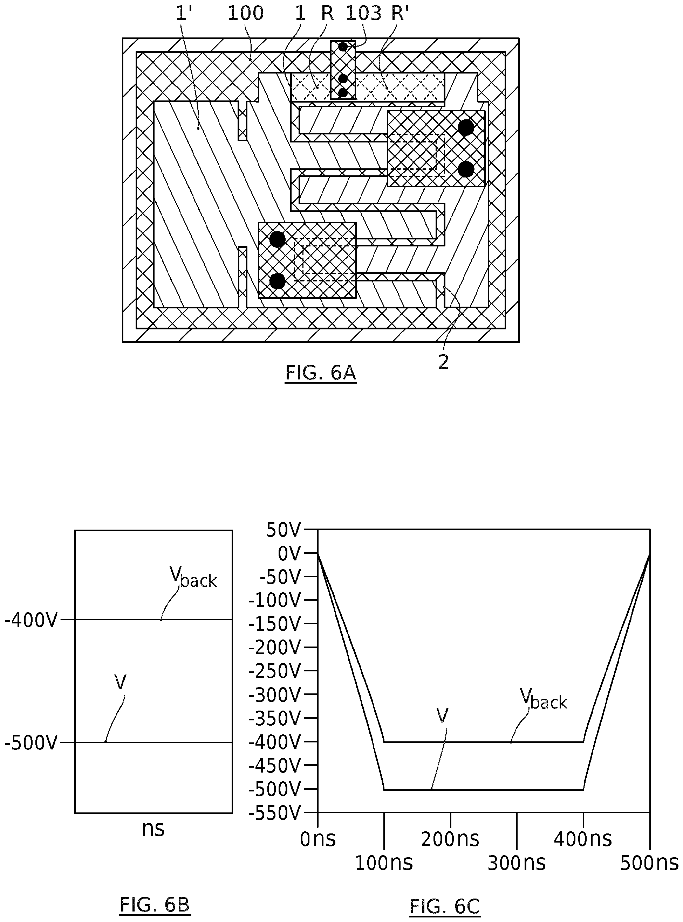

Selon un quatrième mode de réalisation illustré aux figures 2 et 6A, le pont diviseur capacitif est formé par l'électrode additionnelle 1' et le pont diviseur résistif est formé par une première résistance additionnelle R et une deuxième résistance additionnelle R'.

Les ponts diviseurs capacitif et résistif peuvent ainsi être formés indépendamment.

La première résistance additionnelle R est de préférence connectée entre la première électrode 1 et la face arrière 101 du substrat.

La deuxième résistance additionnelle R' est de préférence connectée entre la deuxième électrode 2 et la face arrière 101 du substrat.

La connexion 103 vers la face arrière 101 peut être réalisée à travers le boîtier moulé autour de la puce comprenant le composant de puissance, par exemple par gravure plasma réactive O₂/CF₄.

Selon cet exemple, la première résistance équivalente R1eq est telle que 1/R1eq = 1/R1 + 1/R1' + 1/R et la deuxième résistance équivalente R2eq est telle que 1/R2eq = 1/R2 + 1/R'.

Un tel mode de réalisation permet donc d'ajuster précisément les valeurs de capacité C1eq, C2eq d'une part, et les valeurs de résistance R1eq, R2eq d'autre part.

En particulier, la surface S1' de l'électrode additionnelle 1' peut être réduite de façon à obtenir la capacité C1eq souhaitée, indépendamment de la résistance R1eq souhaitée.

Dans ce mode de réalisation, la surface S1' peut être par exemple d'environ 1mm², et les première et deuxième résistances additionnelles R et R' peuvent être respectivement égales à 87 MOhm environ et 350 MOhm environ.

Pour un tel dimensionnement, la figure 6B montre la tension Vback obtenue par simulation en situation de blocage statique pour une tension V = - 500V. Dans ce cas, Vback est de -400V.

La figure 6C montre la tension Vback obtenue par simulation en situation de blocage dynamique pour une tension V = -500V. Dans ce cas, Vback est également de -400V.

Un tel mode de réalisation permet donc d'éliminer la disparité entre la tension Vback en situation de blocage statique et la tension Vback en situation de blocage dynamique.

Selon un aspect séparable de l'invention, les première et deuxième résistances additionnelles R et R' peuvent être réalisées à partir d'une implantation localisée d'Hélium dans la ou les couches à base de GaN en face avant 100 du substrat 10.

Une étape de recuit consécutive à l'implantation d'hélium permet de créer une zone résistive présentant un comportement ohmique.

En particulier, une implantation d'Hélium à une dose d'environ 5×10¹⁴/cm² suivie d'un recuit à 800°C environ permet d'obtenir un tel comportement ohmique pour une valeur de résistivité de l'ordre de 1,46 MOhm.mm.

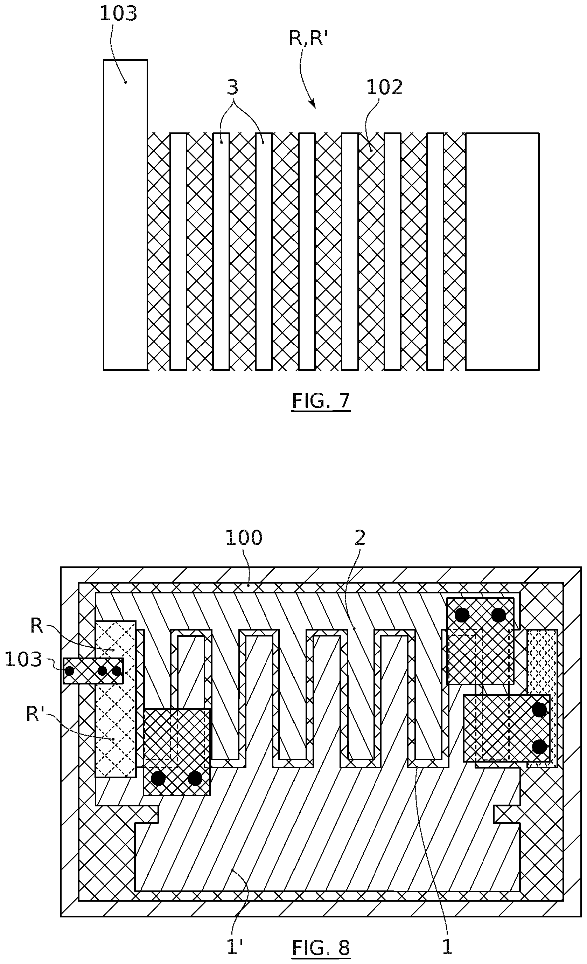

Tel qu'illustré à la figure 7, les première et deuxième résistances additionnelles R et R' sont de préférence réalisées en face avant 100 du substrat sur une zone résistive 102 formée par une première étape d'implantation d'hélium suivie d'une deuxième étape de recuit.

Des éléments métalliques 3 sont ensuite déposés sur cette zone résistive de façon à obtenir la valeur de résistance souhaitée.

Par exemple, douze éléments métalliques 3 présentant chacun une longueur de 200 µm et une largeur de 7 µm peuvent être régulièrement disposés sur la zone résistive 102 selon une direction en largeur et espacés de 9 µm de manière à former une première résistance additionnelle R de valeur 87 MOhm environ.

Quarante-huit éléments métalliques 3 présentant chacun une longueur de 200 µm et une largeur de 7 µm peuvent être régulièrement disposés sur la zone résistive 102 selon la direction en largeur et espacés de 9 µm de manière à former une deuxième résistance additionnelle R' de valeur 350 MOhm environ.

Selon un mode de réalisation illustré à la figure 8, le composant de puissance peut être un transistor HEMT à base de GaN.

Selon ce mode de réalisation préféré, les ponts diviseurs capacitif et résistif sont formés indépendamment.

Le pont diviseur capacitif est formé par l'électrode additionnelle 1' et le pont diviseur résistif est formé par les première et deuxième résistances additionnelles R et R'.

Le dimensionnement des ponts diviseurs capacitif et résistif du circuit de polarisation du transistor HEMT à base de GaN peut se faire mutatis mutandis à partir de celui des ponts diviseurs capacitif et résistif du circuit de polarisation de la diode Schottky à base de GaN.

L'invention n'est pas limitée aux modes de réalisations précédemment décrits et s'étend à tous les modes de réalisation couverts par les revendications.

## Revendications

1. Système comprenant un composant de puissance à base de GaN présentant un état passant et un état bloqué, et comprenant un circuit de polarisation dudit composant de puissance,
ledit composant de puissance étant formé en face avant d'un substrat semiconducteur (10) présentant une face avant (100) et une face arrière (101), et comprenant une première électrode (1) présentant à l'état passant un potentiel électrique V1 et une deuxième électrode (2) présentant à l'état passant un potentiel électrique V2,
le circuit de polarisation comprend un pont diviseur capacitif et un pont diviseur résistif formés au moins en partie sur ledit substrat semiconducteur (10) et configurés pour maintenir en face arrière (101) du substrat semiconducteur (10) un potentiel électrique Vback tel que Vback soit sensiblement égal à k.V avec k un facteur de proportionnalité strictement compris entre 0 et 1, et V étant une tension de fonctionnement à l'état passant du composant telle que V = V1 - V2, le pont diviseur capacitif comprenant un premier condensateur équivalent présentant une première capacité équivalente C1eq et un deuxième condensateur équivalent présentant une deuxième capacité équivalente C2eq telles que 0,9.C2eq.k/(1 - k) ≤ C1eq ≤ 1,1.C2eq.k/(1 - k),
le pont diviseur résistif comprenant un premier résisteur équivalent présentant une première résistance équivalente R1eq et un deuxième résisteur équivalent présentant une deuxième résistance équivalente R2eq telles que 0,9.R2eq.(1 - k)/k ≤ R1eq ≤ 1,1.R2eq.(1 - k)/k,
dans lequel le premier condensateur équivalent comprenant un premier condensateur et un condensateur additionnel, le premier condensateur étant formé par le substrat, la face arrière du substrat et la première électrode (1) en face avant (100) du substrat, et présentant une première capacité C1 entre la face arrière (101) du substrat (10) et la première électrode (1), telle que C1 = E S1/e avec S1 une surface de la première électrode (1), e une épaisseur nominale du substrat, et E une permittivité du substrat, et le condensateur additionnel étant formé par le substrat, la face arrière du substrat et une électrode additionnelle (1') en face avant (100) du substrat connectée à la première électrode (1), et présentant une capacité additionnelle C1' entre la face arrière (101) du substrat (10) et l'électrode additionnelle (1'), telle que C1' = E S1'/e avec S1' une surface de l'électrode additionnelle (1'), e l'épaisseur nominale du substrat, et E la permittivité du substrat, de sorte que la première capacité équivalente C1eq = C1 + C1',
dans lequel le deuxième condensateur équivalent comprend un deuxième condensateur formé par le substrat, la face arrière du substrat et la deuxième électrode (2) en face avant (100) du substrat, et présentant une deuxième capacité C2 entre la face arrière (101) du substrat (10) et la deuxième électrode (2), telle que C2 = E S2/e avec S2 une surface de la deuxième électrode (2), e l'épaisseur nominale du substrat, et E la permittivité du substrat, de sorte que la deuxième capacité équivalente C2eq = C2,
dans lequel le premier résisteur équivalent comprend un premier résisteur et un résisteur additionnel, le premier résisteur étant formé par le substrat, la face arrière du substrat et la première électrode (1) en face avant (100) du substrat, et présentant une première résistance de fuite R1 entre la face arrière (101) du substrat (10) et la première électrode (1), telle que R1 = e/s.S1 avec S1 la surface de la première électrode (1), e l'épaisseur nominale du substrat, et s une conductivité du substrat, et le résisteur additionnel étant formé par le substrat, la face arrière du substrat et l'électrode additionnelle (1') en face avant (100) du substrat connectée à la première électrode (1), et présentant une résistance de fuite additionnelle R1' entre la face arrière (101) du substrat (10) et l'électrode additionnelle (1'), telle que R1' = e/s.S1' avec S1' la surface de l'électrode additionnelle (1'), e l'épaisseur nominale du substrat, et s la conductivité du substrat, de sorte que la première résistance équivalente R 1 eq soit telle que 1 IR 1 eq = 1/R1 + 1/R1',
dans lequel le deuxième résisteur équivalent comprend un deuxième résisteur formé par le substrat, la face arrière du substrat et la deuxième électrode (2) en face avant (100) du substrat, et présentant une deuxième résistance de fuite R2 entre la face arrière (101) du substrat (10) et la deuxième électrode (2), telle que R2 = e/s.S2 avec S2 la surface de la deuxième électrode (2), e l'épaisseur nominale du substrat, et s la conductivité du substrat, de sorte que la deuxième résistance équivalente R2eq = R2.

2. Système selon les revendications précédentes en combinaison dans lequel le premier résisteur équivalent comprend un premier résisteur complémentaire formé en face avant (100) du substrat (10) et le deuxième résisteur équivalent comprend un deuxième résisteur complémentaire formé en face avant (100) du substrat (10), lesdits premier et deuxième résisteurs complémentaires présentant respectivement une première résistance complémentaire R et une deuxième résistance complémentaire R' de sorte que la première résistance équivalente R1eq soit telle que 1 IR 1 eq = 1/R1 + 1/R1' + 1/R et la deuxième résistance équivalente R2eq soit telle que 1/R2eq = 1/R2 + 1/R'.

3. Système selon la revendication précédente dans lequel les premier et deuxième résisteurs complémentaires comprennent chacun une série d'éléments résistifs, lesdits éléments résistifs étant formés par un élément métallique (3) et une zone isolante alternés.

4. Système selon la revendication précédente dans lequel le substrat semiconducteur comprend du nitrure de gallium (GaN) en face avant et dans lequel la zone isolante est formée par une implantation d'hélium (He) dans le GaN suivie d'un recuit.

5. Système selon l'une quelconque des revendications 1 à 4 dans lequel les première et deuxième électrodes (1, 2) présentent chacune des doigts et sont au moins partiellement interdigitées au niveau d'une zone d'interdigitation et l'électrode additionnelle (1') est située en bordure de la zone d'interdigitation.

6. Système selon l'une quelconque des revendications 2. 1 à 5 dans lequel le substrat (10) situé entre l'électrode additionnelle (1') en face avant et la face arrière (101) présente une épaisseur e' strictement inférieure à l'épaisseur nominale e du substrat (10), de sorte que la résistance additionnelle de fuite R1' = e'/s.S1' soit diminuée.

7. Système selon l'une quelconque des revendications 2. 1 à 6 dans lequel les première et deuxième électrodes (1, 2) présentent chacune des doigts et sont au moins partiellement interdigitées au niveau d'une zone d'interdigitation, et l'électrode additionnelle (1') présente des doigts additionnels prolongeant les doigts de la première électrode (1) selon une direction en largeur desdits doigts, de sorte à former des doigts élargis présentant une largeur strictement supérieure, de préférence au moins cinq fois supérieure, à une largeur des doigts de la deuxième électrode (2).

8. Système selon l'une quelconque des revendications précédentes dans lequel le facteur de proportionnalité k est choisi tel que 0,7 < k < 0,9.

9. Système selon l'une quelconque des revendications précédentes dans lequel le composant de puissance est pris parmi une diode Schottky et un transistor HEMT.

## Patentansprüche

1. System mit einem GaN-basierten Leistungsbauteil, das einen leitenden Zustand und einen gesperrten Zustand aufweist, und umfassend eine Schaltung zur Vorspannung des Leistungsbauteils,
wobei das Leistungsbauteil auf der Vorderseite eines Halbleitersubstrats (10) ausgebildet ist, das eine Vorderseite (100) und eine Rückseite (101) aufweist und eine erste Elektrode (1), die im leitenden Zustand ein elektrisches Potenzial V1 aufweist, sowie eine zweite Elektrode (2), die im leitenden Zustand ein elektrisches Potenzial V2 aufweist, umfasst,
die Schaltung zur Vorspannung umfasst eine kapazitive Teilerbrücke und eine resistive Teilerbrücke, die zumindest teilweise auf dem Halbleitersubstrat (10) ausgebildet und so konfiguriert sind, dass sie auf der Rückseite (101) des Halbleitersubstrats (10) ein elektrisches Potential Vback aufrechterhalten, so dass Vback in etwa gleich k.V ist, wobei k ein Proportionalitätsfaktor ist, der deutlich zwischen 0 und 1 liegt, und V eine Betriebsspannung im leitenden Zustand des Bauelements ist, so dass V = V1 - V2 ist, wobei die kapazitive Teilerbrücke einen ersten äquivalenten Kondensator mit einer ersten äquivalenten Kapazität C1eq und einen zweiten äquivalenten Kondensator mit einer zweiten äquivalenten Kapazität C2eq, so dass 0,9.C2eq.k/(1 - k) ≤ C1eq ≤ 1,1.C2eq.k/(1 - k), umfasst,
wobei die resistive Teilerbrücke einen ersten äquivalenten Widerstand mit einem ersten äquivalenten Widerstand R1eq und einen zweiten äquivalenten Widerstand mit einem zweiten äquivalenten Widerstand R2eq, so dass 0,9.R2eq.(1 - k)/k ≤ R1eq ≤ 1,1.R2eq.(1 - k)/k, umfasst,
wobei der erste äquivalente Kondensator einen ersten Kondensator und einen zusätzlichen Kondensator umfasst, wobei der erste Kondensator durch das Substrat, die Rückseite des Substrats und die erste Elektrode (1) an der Vorderseite (100) des Substrats gebildet wird, und eine erste Kapazität C1 zwischen der Rückseite (101) des Substrats (10) und der ersten Elektrode (1) aufweist, so dass C1 = E S1/e ist, wobei S1 eine Fläche der ersten Elektrode (1), e eine nominale Dicke des Substrats und E eine Permittivität des Substrats und eine zusätzliche Elektrode (1') an der Vorderseite (100) des Substrats, die mit der ersten Elektrode (1) verbunden ist, und eine zusätzliche Kapazität C1' zwischen der Rückseite (101) des Substrats (10) und der zusätzlichen Elektrode (1') aufweist, so dass C1' = E S1'/e ist, wobei S1' eine Fläche der zusätzlichen Elektrode (1'), e die nominale Dicke des Substrats und E die Permittivität des Substrats ist, so dass die erste äquivalente Kapazität C1eq = C1 + C1' ist,
wobei der zweite äquivalente Kondensator einen zweiten Kondensator umfasst, der durch das Substrat, die Rückseite des Substrats und die zweite Elektrode (2) an der Vorderseite (100) des Substrats gebildet wird, und eine zweite Kapazität C2 zwischen der Rückseite (101) des Substrats (10) und der zweiten Elektrode (2) aufweist, so dass C2 = E S2/e ist, wobei S2 eine Fläche der zweiten Elektrode (2), e die nominale Dicke des Substrats und E die Permittivität des Substrats ist, so dass die zweite äquivalente Kapazität C2eq = C2 ist,
wobei der erste äquivalente Widerstand einen ersten Widerstand und einen zusätzlichen Widerstand umfasst, wobei der erste Widerstand durch das Substrat, die Rückseite des Substrats und die erste Elektrode (1) an der Vorderseite (100) des Substrats gebildet wird, und einen ersten Ableitungswiderstand R1 zwischen der Rückseite (101) des Substrats (10) und der ersten Elektrode (1) aufweist, so dass R1 = e/s.S1 ist, wobei S1 die Fläche der ersten Elektrode (1), e die nominale Dicke des Substrats und s eine Leitfähigkeit des Substrats ist, und wobei der zusätzliche Widerstand durch das Substrat, die Rückseite des Substrats und die zusätzliche Elektrode (1') an der Vorderseite (100) des Substrats, die mit der ersten Elektrode (1) verbunden ist, gebildet wird, und einen zusätzlichen Ableitungswiderstand R1' zwischen der Rückseite (101) des Substrats (10) und der zusätzlichen Elektrode (1') aufweist, so dass R1' = e/s.S1' ist, wobei S1' die Fläche der zusätzlichen Elektrode (1'), e die nominale Dicke des Substrats und s die Leitfähigkeit des Substrats ist, so dass der erste äquivalente Widerstand R1eq 1/R1eq = 1/R1 + 1/R1' ist,
wobei der zweite äquivalente Widerstand einen zweiten Widerstand umfasst, der durch das Substrat, die Rückseite des Substrats und die zweite Elektrode (2) an der Vorderseite (100) des Substrats gebildet wird, und einen zweiten Ableitungswiderstand (R2) zwischen der Rückseite (101) des Substrats (10) und der zweiten Elektrode (2) aufweist, so dass R2 = e/s.S2 ist, wobei S2 die Fläche der zweiten Elektrode (2), e die nominale Dicke des Substrats, und s die Leitfähigkeit des Substrats ist, so dass der zweite äquivalente Widerstand R2eq = R2 ist.

2. System nach den vorhergehenden Ansprüchen in Kombination, wobei der erste äquivalente Widerstand einen ersten komplementären Widerstand umfasst, der an der Vorderseite (100) des Substrats (10) ausgebildet ist, und der zweite äquivalente Widerstand einen zweiten komplementären Widerstand umfasst, der an der Vorderseite (100) des Substrats (10) ausgebildet ist, wobei der erste und der zweite komplementäre Widerstand jeweils einen ersten komplementären Widerstand R und einen zweiten komplementären Widerstand R' aufweisen, so dass der erste äquivalente Widerstand R1eq so beschaffen ist, dass 1/R1eq = 1/R1 + 1/R1' + 1/R und der zweite äquivalente Widerstand R2eq so beschaffen ist, dass 1/R2eq = 1/R2 + 1/R'.

3. System nach dem vorhergehenden Anspruch, wobei der erste und der zweite komplementäre Widerstand jeweils eine Reihe von Widerstandselementen umfassen, wobei die Widerstandselemente durch ein abwechselndes Metallelement (3) und einen isolierenden Bereich gebildet werden.

4. System nach dem vorhergehenden Anspruch, wobei das Halbleitersubstrat Galliumnitrid (GaN) auf der Vorderseite umfasst und bei dem der isolierende Bereich durch Implantation von Helium (He) in das GaN und anschließendes Ausglühen gebildet wird.

5. System nach einem der Ansprüche 1 bis 4, wobei die erste und die zweite Elektrode (1, 2) jeweils Steckerfinger aufweisen und an einem Verzahnungsbereich zumindest teilweise verzahnt sind und die zusätzliche Elektrode (1') am Rand des Verzahnungsbereichs angeordnet ist.

6. System nach einem der Ansprüche 1 bis 5, wobei das Substrat (10) zwischen der zusätzlichen Elektrode (1') auf der Vorderseite und der Rückseite (101) eine Dicke e' aufweist, die deutlich kleiner ist als die nominale Dicke e des Substrats (10), so dass der zusätzliche Ableitungswiderstand R1' = e'/s.S1' vermindert wird.

7. System nach einem der Ansprüche 1 bis 6, wobei die erste und die zweite Elektrode (1, 2) jeweils Steckerfinger aufweisen und an einem Verzahnungsbereich zumindest teilweise verzahnt sind, und die zusätzliche Elektrode (1') zusätzliche Steckerfinger aufweist, die die Steckerfinger der ersten Elektrode (1) in einer Breitenrichtung der Steckerfinger verlängern, so dass verbreiterte Steckerfinger gebildet werden, die eine Breite aufweisen, die deutlich größer, vorzugsweise mindestens fünfmal größer, als eine Breite der Steckerfinger der zweiten Elektrode (2) ist.

8. System nach einem der vorhergehenden Ansprüche, wobei der Proportionalitätsfaktor k so gewählt wird, dass 0,7 < k < 0,9.

9. System nach einem der vorhergehenden Ansprüche, bei dem das Leistungsbauteil aus einer Schottky-Diode und einem HEMT-Transistor ausgewählt ist.

## Claims

1. A system comprising a GaN-based power component having an on state and an off state, and comprising a biasing circuit of said power component,
said power component being formed on the front face of a semiconductor substrate (10) having a front face (100) and a rear face (101), and comprising a first electrode (1) having, in the on state, an electrical potential V1 and a second electrode (2) having, in the on state, an electrical potential V2,
the biasing circuit comprises a capacitive divider bridge and a resistive divider bridge formed at least partially on said semiconductor substrate (10) and configured to maintain, on the rear face (101) of the semiconductor substrate (10), an electrical potential Vback such that Vback is substantially equal to k.V with k a proportionality factor which is strictly comprised between 0 and 1, and V being an operating voltage in the on state of the component such that V = V1 - V2, the capacitive divider bridge comprising a first equivalent capacitor having a first equivalent capacitance C1eq and a second equivalent capacitor having a second equivalent capacitance C2eq such that 0.9.C2eq.k/(1 - k) ≤ C1eq ≤ 1.1.C2eq.k/(1 - k),
the resistive divider bridge comprising a first equivalent resistor having a first equivalent resistance R1eq and a second equivalent resistor having a second equivalent resistance R2eq such that 0.9.R2eq.(1 - k)/k ≤ R1eq ≤ 1.1.R2eq.(1 - k)/k, wherein the first equivalent capacitor comprising a first capacitor and an additional capacitor, the first capacitor being formed by the substrate, the rear face of the substrate and the first electrode (1) on the front face (100) of the substrate, and having a first capacitance C1 between the rear face (101) of the substrate (10) and the first electrode (1), such that C1 = E S1/e with S1 a surface area of the first electrode (1), e a nominal thickness of the substrate, and E a permittivity of the substrate, and the additional capacitor being formed by the substrate, the rear face of the substrate and an additional electrode (1') on the front face (100) of the substrate which is connected to the first electrode (1), and having an additional capacitance C1' between the rear face (101) of the substrate (10) and the additional electrode (1'), such that C1'= E S17e with S1' a surface area of the additional electrode (1'), e the nominal thickness of the substrate, and E the permittivity of the substrate, such that the first equivalent capacitance C1eq = C1 + C1',
wherein the second equivalent capacitor comprises a second capacitor formed by the substrate, the rear face of the substrate and the second electrode (2) on the front face (100) of the substrate, and having a second capacitance C2 between the rear face (101) of the substrate (10) and the second electrode (2), such that C2 = E S2/e with S2 a surface area of the second electrode (2), e the nominal thickness of the substrate, and E the permittivity of the substrate, such that the second equivalent capacitance C2eq = C2,
wherein the first equivalent resistor comprises a first resistor and an additional resistor, the first resistor being formed by the substrate, the rear face of the substrate and the first electrode (1) on the front face (100) of the substrate, and having a first leakage resistance R1 between the rear face (101) of the substrate (10) and the first electrode (1), such that R1 = e/s.S1 with S1 the surface area of the first electrode (1), e the nominal thickness of the substrate, and s a conductivity of the substrate, and the additional resistor being formed by the substrate, the rear face of the substrate and the additional electrode (1') on the front face (100) of the substrate which is connected to the first electrode (1), and having an additional leakage resistance R1' between the rear face (101) of the substrate (10) and the additional electrode (1'), such that R1' = e/s.S1' with S1' the surface area of the additional electrode (1'), e the nominal thickness of the substrate, and s the conductivity of the substrate, such that the first equivalent resistance R1eq is such that 1/R1eq = 1/R1 +1R1',
wherein the second equivalent resistor comprises a second resistor formed by the substrate, the rear face of the substrate and the second electrode (2) on the front face (100) of the substrate, and having a second leakage resistance R2 between the rear face (101) of the substrate (10) and the second electrode (2), such that R2 = e/s.S2 with S2 the surface area of the second electrode (2), e the nominal thickness of the substrate, and s the conductivity of the substrate, such that the second equivalent resistance R2eq = R2.

2. The system according to the preceding claims in combination wherein the first equivalent resistor comprises a first complementary resistor formed on the front face (100) of the substrate (10) and the second equivalent resistor comprises a second complementary resistor formed on the front face (100) of the substrate (10), said first and second complementary resistors having respectively a first complementary resistance R and a second complementary resistance R' such that the first equivalent resistance R1eq is such that 1/R1eq = 1/R1 + 1/R1' + 1/R and the second equivalent resistance R2eq is such that 1/R2eq = 1/R2 + 1/R'.

3. The system according to the preceding claim wherein the first and second complementary resistors each comprise a series of resistive elements, said resistive elements being formed by a metal element (3) and an insulating area which are alternating.

4. The system according to the preceding claim wherein the semiconductor substrate comprises gallium nitride (GaN) on the front face and wherein the insulating area is formed by an implantation of helium (He) in the GaN followed by an annealing.

5. The system according to any one of claims 1 à 4 wherein the first and second electrodes (1, 2) each have fingers and are at least partially interdigitated at an interdigitation area and the additional electrode (1') is located on the edge of the interdigitation area.

6. The system according to any one of claims 1 to 5 wherein the substrate (10) located between the additional electrode (1') on the front face and the rear face (101) has a thickness e' which is strictly less than the nominal thickness e of the substrate (10), such that the additional leakage resistance R1' = e'/s.S1' is reduced.

7. The system according to any one of claims 1 to 6 wherein the first and second electrodes (1, 2) each have fingers and are at least partially interdigitated at an interdigitation area, and the additional electrode (1') has additional fingers extending the fingers of the first electrode (1) along a width direction of said fingers, so as to form widened fingers having a width which is strictly greater, preferably at least five times greater, than a width of the fingers of the second electrode (2).

8. The system according to any one of the preceding claims wherein the proportionality factor k is selected such that 0.7 < k < 0.9.

9. The system according to any one of the preceding claims wherein the power component is taken from a Schottky diode and a HEMT transistor.
